**Europäisches Patentamt**

**European Patent Office**

**Office européen des brevets**

(19)

(11) Veröffentlichungsnummer: **0 072 522
B1**

(12) # EUROPÄISCHE PATENTSCHRIFT

(45) Veröffentlichungstag der Patentschrift:
04.12.85

(21) Anmeldenummer: 82107238.6

(22) Anmeldetag: 10.08.82

(51) Int. Cl.⁴: **H 01 L 21/60, H 01 L 21/90,
H 01 L 23/52, H 01 L 29/62**

(54) Verfahren zum Herstellen von integrierten MOS-Feldeffekttransistoren, insbesondere von komplementären MOS-Feldeffekttransistorschaltungen mit einer aus Metallsiliziden bestehenden zusätzlichen Leiterbahnebene.

(30) Priorität: 19.08.81 DE 3132809

(43) Veröffentlichungstag der Anmeldung:
23.02.83 Patentblatt 83/8

(45) Bekanntmachung des Hinweises auf die Patenterteilung:
04.12.85 Patentblatt 85/49

(84) Benannte Vertragsstaaten:
AT DE FR GB IT SE

(56) Entgegenhaltungen:
EP - A - 0 017 697
DE - A - 2 906 249
FR - A - 2 351 501

IBM TECHNICAL DISCLOSURE BULLETIN, Band 23, Nr. 6, November 1980, Seiten 2563-2566, New York, USA V.L.RIDEOUT: "Methode of fabricating MOSFET integrated circuits with low resistivity interconnection lines"
IEEE JOURNAL OF SOLID-STATE CIRCUITS, Band SC-15, Nr. 4, August 1980, Seiten 474-482, New York, USA S.P.MURARKA et al.:" Refractory silicides of titanium and tantalum for low-resistivity gates and interconnects"

(73) Patentinhaber: Siemens Aktiengesellschaft, Berlin und München Wittelsbacherplatz 2, D-8000 München 2 (DE)

(72) Erfinder: Schwabe, Ulrich, Dr., Grünwalderstrasse 40, D-8000 München 90 (DE)

## Beschreibung

Die vorliegende Patentanmeldung betrifft ein Verfahren zum Herstellen von integrierten MOS-Feldeffekttransistoren, insbesondere von komplementären MOS-Feldeffekttransistorschaltungen (CMOS-FETs), bei dem als zusätzliche Leiterbahnebene eine aus hochschmelzenden Metallsiliziden, wie Siliziden von Molybdän, Wolfram, Tantal oder Titan bestehende Metallschichtstruktur verwendet wird, wobei die Metallsilizide nach Fertigstellung der Polysiliziumebene, der Erzeugung der aktiven MOS-Bereiche, dem Aufbringen des Isolationsoxids und dem Öffnen der Kontaktlöcher aufgebracht werden, und bei dem als Zwischenoxid zwischen der Metallsilizidebene und der Metall-Leiterbahnebene eine Phosphorglasschicht verwendet wird.

Ein solches Verfahren ist bereits in der deutschen Patentanmeldung P 3 027 954.0 vorgeschlagen worden. Dieses Verfahren läßt sich noch gut auf die Herstellung von integrierten MOS-Feldeffekttransistoren anwenden. Bei der Übertragung der Prozeßschritte auf die Herstellung von komplementären MOS-Feldeffekttransistorschaltungen (CMOS-Schaltungen) ergeben sich jedoch Schwierigkeiten, weil das Verrunden der Ränder und Kanten in den Kontaktlochbereichen nur noch vor der Kontaktlochätzung durchgeführt werden kann, weil sonst die $p^+$-Bereiche freiliegen und eine Verarmung an Dotierstoff in diesen Bereichen durch die angewandten hohen Temperaturen stattfindet.

Es ist bereits aus der DE-A-2 906 249 bekannt, zur Vermeidung der Ausbildung unerwünschter PN-Übergänge zwischen hochdotierten Bereichen des einen Leitfähigkeitstyps eines Halbleiterkörpers und polykristallinen Siliziumleiterschichten des anderen Leitfähigkeitstyps in den Kontaktlochbereichen eine Metallsilicidschicht vorzusehen.

Auch tritt beim Öffnen der Kontaktlöcher (Aluminium zu $n^+$-Bereichen, Aluminium zu $p^+$-Bereichen und Aluminium zu Polysiliziumbereichen) bei den integrierten CMOS- und NMOS-Schaltungen, bei denen eine zusätzliche Leiterbahnebene verwendet wird, das Problem auf, daß in unterschiedlich dicke Oxidschichten geätzt werden muß, was ein starkes Unterätzen der Kontaktlöcher zur Folge hat.

Die Aufgabe, die der vorliegenden Erfindung zugrunde liegt, besteht deshalb darin, ein Verfahren zur Herstellung von insbesondere CMOS-Schaltungen unter Verwendung einer zusätzlichen, aus Metallsiliziden bestehenden zweiten Leiterbahnebene anzugeben, bei dem

1. ein Verfließenlassen der als Zwischenoxid dienenden Phosphorglasschicht zum Verrunden der Kontaktlöcher möglich ist, ohne daß die $p^+$-Bereiche der Schaltung freiliegen und

2. die Kontaktlöcher keine Unterätzungen aufweisen.

Die Aufgabe wird bei einem Verfahren der eingangs genannten Art dadurch gelöst, daß die Kontakte zu den aktiven MOS- und Polysiliziumbereichen sowohl für die Metallsilizidebene als auch für die Metall-Leiterbahnebene nach dem Aufbringen des Isolationsoxids und vor der Abscheidung der Metallsilizide in einem Verfahrensschritt gleichzeitig geöffnet werden und daß die Strukturierung der Metallsilizidebene so ausgeführt wird, daß beim späteren Verfließenlassen der als Zwischenoxid wirkenden Phosphorglasschicht die $p^+$-Bereiche der Schaltung einschließlich der Kanten ihrer Kontaktlöcher im Isolationsoxid von der Metallsilizidschicht abgedeckt bleiben.

Es liegt im Rahmen der Erfindung, als Metallsilizidschicht Tantalsilizid ($TaSi_2$) in einer Schichtdicke von 200 bis 500 nm und als Metall-Leiterbahnebene Aluminium zu verwenden. Die als Zwischenoxid wirkende Phosphorglasschicht wird vorzugsweise in einer Schichtdicke von 1000 nm abgeschieden und bei einer Temperatur von 1000° C zum Verfließen gebracht.

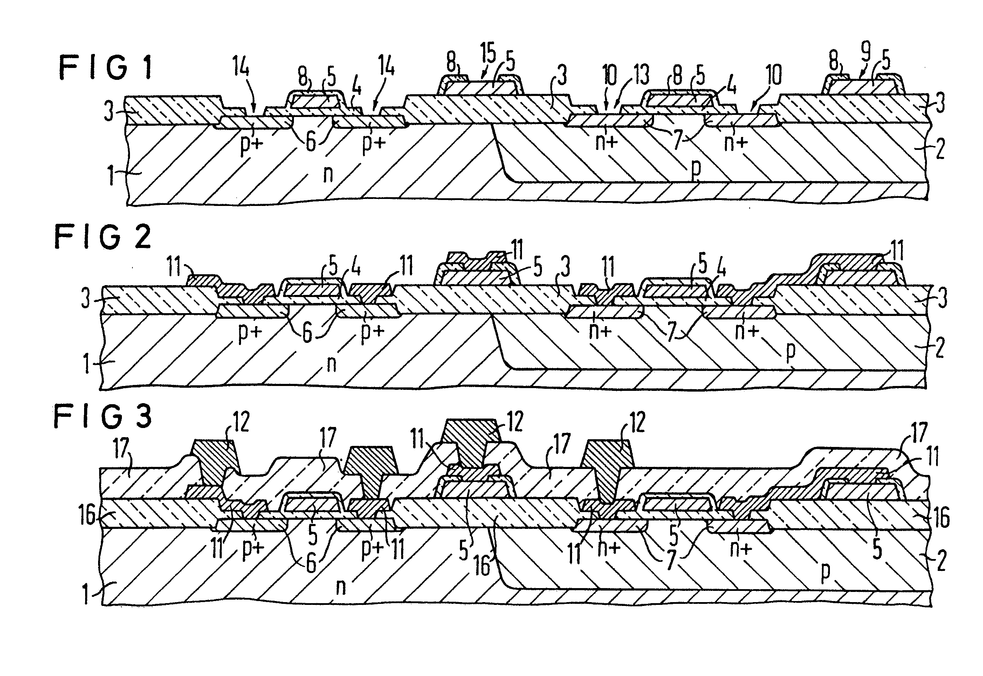

Anhand eines Ausführungsbeispiels und der Figuren 1 bis 3, welche im Schnittbild die beim Verfahren in den verschiedenen Stadien entstehenden erfindungswesentlichen Strukturen schematisch darstellen, wird im folgenden die Erfindung für einen p-Wannen-CMOS-Prozeß noch näher erläutert.

### Figur 1

Bei einem p-Wannen-CMOS-Prozeß wird folgendermaßen vorgegangen: Auf einem, mit Phosphor dotiertem Siliziumsubstrat 1 wird zum Ausbilden der p-Wannen 2 Bor implantiert und in einem Hochtemperaturschritt eingetrieben. Danach wird die Schichtfolge für die lokale Oxidation erzeugt, die aktiven Bereiche definiert, die p-Wannenbereiche 2 mit Fotolack abgedeckt, Phosphor in die Feldbereiche implantiert, der Fotolack entfernt, die Feldoxidbereiche 3 mittels lokaler Oxidation erzeugt, die Siliziumnitridmaske entfernt und Bor zur Einstellung der Einsatzspannung der n- und p-MOS-FETs implantiert. Anschließend wird das Gateoxid 4 neu aufgewachsen, eine 350 nm dicke Polysiliziumschicht 5 abgeschieden und mit Phosphor dotiert, die Polysiliziumschicht 5 strukturiert, alle Bereiche außer den Source-Drain-Bereichen 6 der p-MOS-FETs und den Kontaktbereichen zum n-Substrat 1 mit Fotolack abgedeckt und Bor implantiert, der Fotolack entfernt, alle Bereiche außer den Source-Drain-Bereichen der n-MOS-FETs 7 und den Kontaktbereichen zu den p-Wannen 2 abgedeckt, Arsen implantiert und der Fotolack entfernt. Dann wird die gesamte Anordnung in feuchter Atmosphäre bei 800 bis 900° C oxidiert. Das so gebildete Isolationsoxid 8 hat über den Polysiliziumbereichen 5 eine Dicke von ca. 200 nm. Es werden nun sowohl die Kontakte für die zusätzliche aus Tantalsilizid bestehende Lei-

terbahnebene 11 für TaSi$_2$-Polysiliziumebene 9, TaSi$_2$-n$^+$-Bereiche 10, als auch die Kontakte für die aus Aluminium bestehende Leiterbahnebene 12 für die Aluminium-n$^+$-Bereiche 13, Aluminium-p$^+$-Bereiche 14, Aluminium-Polysiliziumebene 15 geöffnet. Die Strukturierung ist aus Figur 1 ersichtlich.

### Figur 2

Nach erfolgter erster Kontaktlochätzung wird die aus Tantalsilizid bestehende zusätzliche Leiterbahnebene 11 in einer Schichtdicke von 200 bis 500 nm abgeschieden und so strukturiert, daß über allen Kontakten 9, 10, 13, 14, 15 ein übergroßer Tantalsilizidfleck verbleibt.

### Figur 3

Die gesamte, aus Gateoxid 4, Feldoxid 3 und Isolationsoxid 8 bestehende Oxidschicht wird der besseren Übersicht wegen in Figur 3 mit dem Bezugszeichen 16 bezeichnet. Es wird nun das aus Phosphorsilikatglas bestehende Zwischenoxid 17 in einer Schichtdicke von 1000 nm abgeschieden und die zweite Kontaktlochätzung (Kontakte 13, 14, 15) durchgeführt. Im Anschluß daran erfolgt das Verfließenlassen der Phosphorglasschicht 17 zum Abrunden der Kontaktlochbereiche (13, 14, 15), wobei jetzt die p$^+$-Bereiche 6 durch die über ihnen liegende Teile der Tantalsilizid-Schicht 11 maskiert werden. Abschließend wird in bekannter Weise die aus Aluminium oder Aluminium/Silizium bestehende Leiterbahnebene 12 erzeugt.

Die Verwendung des »Silizidpilzes« über jedem Kontakt (9, 10, 13, 14, 15) bringt neben dem Vorteil, daß das Verfließenlassen der Phosphorglasschicht 17 bei der Herstellung von CMOS-Schaltungen nach der zweiten Kontaktlochätzung erfolgen kann, weil die p$^+$-Bereiche (7) durch die »Silizid-Pilze« maskiert werden, den Vorteil, daß gleiche Oxiddicken über allen Bereichen bei der zweiten Kontaktlochätzung vorliegen, wodurch das Unterätzen vermieden wird.

Außerdem wird die Packungsdichte der so hergestellten integrierten Schaltungen verbessert, da die Kontaktlöcher 2, wie aus Figur 3 ersichtlich ist, auch über Dickoxidbereiche gelegt werden können.

### Patentansprüche

1. Verfahren zum Herstellen von integrierten MOS-Feldeffekttransistoren, insbesondere von komplementären MOS-Feldeffekttransistorschaltungen (CMOS-FETs), bei dem als zusätzliche Leiterbahnebene (11) eine aus hochschmelzenden Metallsiliziden, wie Siliziden von Molybdän, Wolfram, Tantal oder Titan bestehende Metallschichtstruktur verwendet wird, wobei die Metallsilizide nach Fertigstellung der Polysiliziumebene (5), der Erzeugung der aktiven MOS-Bereiche (6, 7), dem Aufbringen des Isolationsoxids (8) und dem Öffnen der Kontaktlöcher aufgebracht werden, und bei dem als Zwischenoxid (17) zwischen der Metallsilizidebene (11) und der Metall-Leiterbahnebene (12) eine Phosphorglasschicht verwendet wird, dadurch gekennzeichnet, daß die Kontakte (9, 10, 13, 14, 15) zu den aktiven MOS- und Polysiliziumbereichen sowohl für die Metallsilizidebene (11) als auch für die Metall-Leiterbahnebene (12) nach dem Aufbringen des Isolationsoxids (8) und vor der Abscheidung der Metallsilizide in einem Verfahrensschritt gleichzeitig geöffnet werden und daß die Strukturierung der Metallsilizidebene (11) so ausgeführt wird, daß beim späteren Verfließenlassen der als Zwischenoxid (17) wirkenden Phosphorglasschicht die p$^+$-Bereiche (6) der Schaltung einschließlich der Kanten ihrer Kontaktlöcher im Isolationsoxid (3, 4, 8, 16) abgedeckt bleiben (Figur 3).

2. Verfahren nach Anspruch 1, dadurch gekennzeichnet, daß als Metallsilizidschicht (11) Tantalsilizid (TaSi$_2$) in einer Schichtdicke von 200 bis 500 nm verwendet wird.

3. Verfahren nach Anspruch 1 und/oder 2, dadurch gekennzeichnet, daß für die Erzeugung der Metall-Leiterbahnebene (12) Aluminium verwendet wird.

4. Verfahren nach einem der Ansprüche 1 bis 3, dadurch gekennzeichnet, daß die Phosphorglasschicht (17) in einer Schichtdicke von 1000 nm abgeschieden und bei einer Temperatur von 1000°C zum Verfließen gebracht wird.

### Claims

1. A process for manufacturing integrated MOS-field effect transistors, in particular circuits having complementary MOS-field effect transistors (CMOS-FETs), in which a metal layer structure of high melting metal silicides, such as silicides of molybdenum, tungsten, tantalum, or titanium, is used as an additional conductor path plane (11), where the metal silicides are applied after completion of the polysilicon plane (5), the production of the active MOS-regions (6, 7), the application of the insulating oxide (8) and the opening of the contact apertures, and in which a phosphorus glass layer is used as an intermediate oxide (17) between the metal silicide plane (11) and the metal conductor path plane (12), characterised in that the contacts (9, 10, 13, 14, 15) to the active MOS and polysilicon regions for both the metal silicide plane (11) and also for the metal conductor path plane (12) are simultaneously opened in one process step after the application of the insulating oxide (8) and before the deposition of the metal silicides; and that the structure of the metal silicide plane (11) is so designed that, when the phosphorus glass layer, which acts as intermediate oxide (17), is later allowed to flow away, the p$^+$-regions (6) of the circuit, including the edges of their contact apertures in the insulating oxide (3, 4, 8, 16), remain covered by the metal silicide layer (11) (Figure 3).

2. A process as claimed in Claim 1, characterised in that tantalum silicide (TaSi$_2$) in a thickness of 200 to 500 nm is used as metal silicide layer (11).

3. A process as claimed in Claim 1 and/or Claim 2, characterised in that aluminium is used for the production of the metal conductor path plane (12).

4. A process as claimed in one of Claims 1 to 3, characterised in that the phosphorus glass layer (17) is deposited in a thickness of 1000 nm and brought to the state at which it will flow away at a temperature of 1000° C.

**Revendications**

1. Procédé de fabrication de transistors intégrés à effet de champ MOS, notamment de circuits à transistors complémentaires à effet de champ MOS (CMOS-FET), qui consiste à utiliser, comme plan supplémentaire des pistes conductrices (11), une structure à couche métallique en siliciures métalliques à points de fusion élevés, comme des siliciures de molybdène, de tungstène, de tantale ou de titane, les siliciures métalliques étant déposés après la réalisation du plan de polysilicium (5), la production des régions MOS actives (6, 7), le dépôt de l'oxyde isolant (8) et l'ouverture des trous pour les contacts, et à utiliser, comme oxyde intermédiaire (17) entre le plan de siliciure métallique (11) et le plan de pistes conductrices (12), une couche de verre au phosphore, caractérisé en ce qu'il consiste à ouvrir simultanément et en une seule phase opératoire, les contacts (9, 10, 13, 14, 15) vers les régions MOS actives et de polysilicium, tant pour le plan de siliciure métallique (11) que pour le plan des pistes conductrices (12), après le dépôt de l'oxyde isolant (8) et avant le dépôt du siliciure métallique, et à exécuter la structuration du plan de siliciure métallique (11) de manière à ce que, lors de la liquéfaction ultérieure de la couche de verre au phosphore servant d'oxyde intermédiaire (17), les régions (6) de type p$^+$ du circuit, y compris les bords de leurs trous pour les contacts dans l'oxyde isolant (3, 4, 8, 16), restent recouvertes par la couche de siliciure métallique (11) (figure 3).

2. Procédé suivant la revendication 1, caractérisé en ce qu'il consiste à utiliser comme couche de siliciure métallique (11) du siliciure de tantale (TaSi$_2$) en une épaisseur de couche de 200 à 500 nm.

3. Procédé suivant la revendication 1 ou 2, caractérisé en ce qu'il consiste à utiliser de l'aluminium pour la production du plan de piste conductrice métallique (12).

4. Procédé suivant l'une des revendications 1 à 3, caractérisé en ce qu'il consiste à déposer la couche de verre au phosphore (17) en une épaisseur de couche de 1000 nm et à la porter à la liquéfaction à une température de 1000° C.

# FIG 1

3 — 14 — 8 5 4 14 — 8 15 5 — 3 — 10 13 8 5 4 10 — 8 9 5 — 3

p+ 6 p+ n+ 7 n+ — 2

1 — n — p

# FIG 2

11 5 4 11 11 5 3 11 5 4 11

3 — p+ 6 p+ n+ 7 n+ — 3

1 — n — p — 2

# FIG 3

17 — 12 17 11 12 17 12 17

16 — 11 p+ 6 p+ 11 5 16 11 n+ 7 5 11 n+ 5 — 16

1 — 5 n 16 p — 2

0 072 522